# EUROPEAN PATENT APPLICATION

(11) **EP 4 658 005 A1**
(43) Date of publication of application: **03.12.2025**
(21) Application number: 23918388.2
(22) Date of filing: 26.01.2023
(51) Int. Cl.: H05K 7/20, B32B 7/027, H01L 23/36

(54) **LAMINATED STRUCTURE**

(71) Applicant: MITSUBISHI ELECTRIC CORPORATION, Chiyoda-ku Tokyo 100-8310 (JP)
(72) Inventor: KOYAMA, Tatsuya, Tokyo 100-8310 (JP); ITO, Yohei, Tokyo 100-8310 (JP); KUME, Masami, Tokyo 100-8310 (JP)
(74) Representative: Meissner Bolte Partnerschaft mbB
(86) International application number: PCT/JP2023/002489
(87) International publication number: WO 2024/157423

(57) **Abstract**

Provided is a laminated structure that suppresses breakage of the thermally conductive material due to the thermal expansion difference between the thermally conductive material and a heat pipe, a heat generating device, or the like. The laminated structure (1) includes a core (11), and a skin (12) provided on at least one surface of the core (11). The skin (12) includes a plurality of thermally conductive materials (17) extending in a plane including the skin (12), and a plurality of fiber bundles (18) extending in a direction different from the extending direction of the thermally conductive materials (17) in the plane including the skin (12), and in a plurality of regions where the plurality of thermally conductive materials (17) and the plurality of fiber bundles (18) overlap, formation of the plurality of regions adjacent to each other are such that positions of the thermally conductive materials (17) and the fiber bundles (18) in the thickness direction of the skin are alternately switched.

## Description

### Technical Field

The present invention relates to a laminated structure to be used for an artificial satellite or the like.

### Background Art

In the related art, a sandwich structure including a core material and fiber reinforced materials disposed on both surfaces of the core material, in which at least one of the fiber reinforced materials includes a sheet-shaped thermally conductive material, is disclosed (for example, Patent Document 1).

### Prior Art Document

### Patent Document

Patent Document 1
International Publication No. WO2021/106563

### Summary of the Invention

### Problems to be Solved by the Invention

However, the conventional technique has a problem that the thermally conductive material is broken due to a difference in the thermal expansion between the sheet-shaped thermally conductive material and a heat generating device or the like adjacent to the sandwich structure being an example of the laminated structure.

The present invention has been made to solve the above-described problem, and an object of the present invention is to provide a laminated structure that suppresses breakage of a thermally conductive material due to a difference in the thermal expansion between a heat pipe, a heat generating device, or the like and the thermally conductive material.

### Means for Solving the Problems

A laminated structure according to the present invention is provided with a core, and a skin disposed on at least one surface of the core. The skin includes a plurality of thermally conductive materials extending in a plane including the skin, and a plurality of fiber bundles extending in a direction different from the extending direction of the thermally conductive materials in the plane including the skin, and in a plurality of regions where the plurality of thermally conductive materials and the plurality of fiber bundles overlap, formation of the plurality of regions adjacent to each other are such that positions of the thermally conductive materials and the fiber bundles in the thickness direction of the skin are alternately switched.

### Effects of the Invention

According to a laminated structure of the present invention, it is possible to suppress breakage of a thermally conductive material due to a difference in the thermal expansion between a heat pipe or a heat generating device and a thermally conductive material.

### Brief Description of the Drawings

FIG. 1 is a perspective view of a laminated structure according to Embodiment 1 of the present invention.
FIG. 2 is a perspective view of the laminated structure and a heat generating device according to Embodiment 1 of the present invention.
FIG. 3 is a schematic diagram corresponding to a cross section of a skin arrowed at a line B-B' in FIG. 1 according to Embodiment 1 of the present invention.
FIG. 4 is a schematic top view of a thermally conductive layer according to Embodiment 1 of the present invention.
FIG. 5 is a schematic diagram corresponding to a cross section of the thermally conductive layer arrowed at a line C-C' in FIG. 4 according to Embodiment 1 of the present invention.
FIG. 6 is a schematic diagram corresponding to a cross section of the thermally conductive layer taken along a line D-D' in FIG. 4 according to Embodiment 1 of the present invention.
FIG. 7 is a perspective view of a laminated structure according to Embodiment 2 of the present invention.
FIG. 8 is a schematic diagram corresponding to a cross section of a skin taken along the line B-B' in FIG. 1 according to Embodiment 3 of the present invention.

### Detailed Description of the Invention

Hereinafter, embodiments of the present invention will be described with reference to the accompanying drawings. The drawings are schematically illustrated, and the size and positional relationships shown in different drawings are not necessarily accurate and may be changed as appropriate. In the following description, the same components are denoted by the same reference numerals, and the names and functions thereof are also the same or similar. Therefore, detailed description thereof may be omitted.

### Embodiment 1

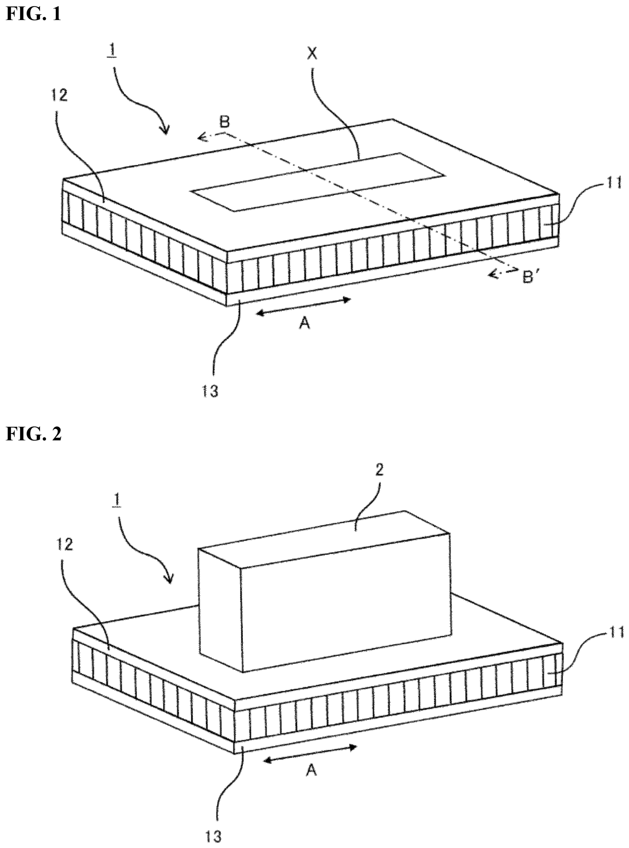

A laminated structure 1 according to Embodiment 1 will be described with reference to FIG. 1 to FIG. 6. FIG. 1 is a perspective view of the laminated structure 1 according to Embodiment 1. The laminated structure may, for example, include a sandwich panel.

As shown in FIG. 1, the laminated structure 1 according to the present embodiment includes a core 11 being a core material, a skin 12 provided on an upper surface of the core 11, and a skin 13 provided on a surface of the core 11 opposite to the surface on which the skin 12 is provided. The core 11 is provided between the skin 12 and the skin 13. For example, a structure in which the skin 12 and the skin 13 sandwich the core 11 from both sides is referred to as a sandwich structure. For example, the core 11 is a flat plate having a thickness and extending in a two-dimensional direction.

FIG. 2 is a perspective view of the laminated structure 1 and a heat generating device 2 according to Embodiment 1. As shown in FIG. 2, the laminated structure 1 is provided adjacent to the heat generating device 2. The heat generating device 2 is installed, for example, adjacent to the skin 12 of the laminated structure 1.

A frame line X in FIG. 1 indicates a region on the skin 12, and the frame line X is, for example, a rectangle. The heat generating device 2 is mounted along the shape of the frame line X. That is, the heat generating device 2 is in contact with the skin 12 within the region of the frame line X. The skin 12 and the heat generating device 2 may not be in direct contact with each other and may be in contact with each other via another member.

The heat generated in the heat generating device 2 is transmitted to the skin 12 adjacent to the heat generating device 2. The heat transferred to the skin 12 is transferred to the skin 13 that is not adjacent to the heat generating device 2 through the core 11 and is dissipated through radiation.

Further, the heat transferred from the heat generating device 2 to the skin 12 may be dissipated through radiation from a region of the skin 12 with which the heat generating device 2 is not in contact, that is, the region which is not surrounded by the frame line X.

Although FIG. 1 and FIG. 2 show an example in which the heat generating device 2 is provided on the side of the skin 12, the present invention is not limited to this, and the heat generating device 2 may be provided on the side of the skin 13. Further, the heat generating devices 2 may be provided on both the sides of the skin 12 and the skin 13.

Although FIG. 2 shows a case where one heat generating device 2 is provided, a plurality of the heat generating devices 2 may be provided adjacent to the skin 12 or the skin 13.

A direction A shown in FIG. 1 and FIG. 2 is a direction in which a length in the region of the heat generating device 2 in contact with the skin 12 in the plane including the skin 12 is the largest compared to other directions in the plane including the skin 12.

When the heat generating device 2 has, for example, a rectangular parallelepiped shape, the direction A may be the direction of the long side of the heat generating device 2 in the plane including the skin 12. When the direction of the long side of the heat generating device 2 is defined as the direction A, the direction of the short side of the heat generating device 2 in the plane including the skin 12 is orthogonal to the direction A.

The heat generating device 2 may not be a rectangular parallelepiped, but may be a square pole, a cylinder, or the like, or may not be in a columnar shape.

The core 11, which is a core material of the laminated structure 1, preferably has a honeycomb structure. The honeycomb structure refers to a structure formed of a planar assembly of hollow columnar cells. The core 11 having the honeycomb structure can be lightweight and highly rigid.

In addition, a material forming the core 11 in the case of the honeycomb structure is preferably an aluminum alloy. The core 11 is formed of an aluminum alloy, and thus it is possible to obtain the core 11 that has high thermal conductivity and is light-weighted while suppressing the cost.

Note that the material forming the core 11 may be carbon fiber reinforced plastic or carbon fiber reinforced carbon.

Further, the core 11 may be formed using a foamed resin, a foamed aluminum alloy, or the like.

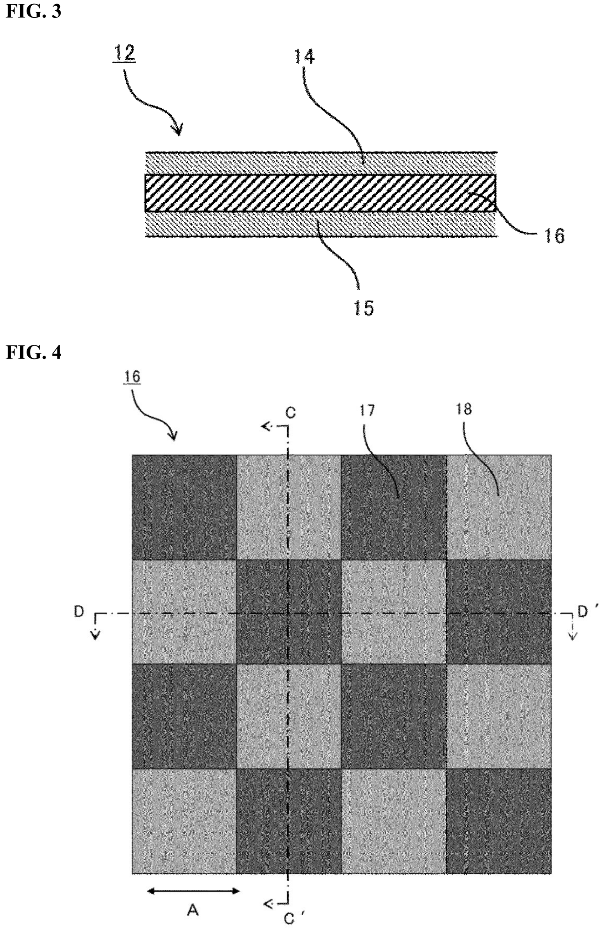

FIG. 3 is a schematic diagram corresponding to a cross section of the skin 12 arrowed at a line B-B' in FIG. 1 according to Embodiment 1.

As shown in FIG. 3, the skin 12 includes a skin outer layer 14, a skin outer layer 15, and a thermally conductive layer 16.

The skin outer layer 15 is provided on a surface of the skin 12 on the side of the core 11. The skin outer layer 14 is provided on a surface of the skin 12 opposite to the surface on the side of the core 11. That is, the thermally conductive layer 16 is provided between the skin outer layer 14 and the skin outer layer 15.

Although the skin 12 has been described here as including the skin outer layer 14, the skin outer layer 15, and the thermally conductive layer 16, the skin 13 may have the same structure.

The structure of the thermally conductive layer 16 will be described in more detail below. FIG. 4 is a schematic top view of the thermally conductive layer 16 according to Embodiment 1. An upper surface refers to a surface of the thermally conductive layer 16 on the side of the skin outer layer 14.

As shown in FIG. 4, the thermally conductive layer 16 includes a plurality of thermally conductive materials 17 and a plurality of fiber bundles 18. FIG. 4 schematically shows a state in which a plurality of belt-like, fibrous, or bundle-like thermally conductive materials 17 extending in the vertical direction of the paper of FIG. 4 and the plurality of fiber bundles 18 extending in the horizontal direction of the paper of FIG. 4 are interwoven with each other.

The thermally conductive material 17 is, for example, sheet-shaped and has a rectangular shape that is long in one direction and has a large difference between a long side and a short side. The plurality of thermally conductive materials 17 extend in a plane including the skin 12.

When the thermally conductive material 17 has, for example, a rectangular shape extending long in one direction, a decrease in the thermal conductivity of the thermally conductive material 17 can be suppressed compared to when the thermally conductive material 17 is broken due to stress applied to the thermally conductive material 17.

The plurality of fiber bundles 18 extend in a direction different from the extending direction of the thermally conductive materials 17 in a plane including the skin 12. In FIG. 4, for example, the plurality of thermally conductive materials 17 and the plurality of fiber bundles 18 are orthogonal to each other.

The plurality of thermally conductive materials 17 and the plurality of fiber bundles 18 are interwoven with each other. That is, in the plurality of regions where the plurality of thermally conductive materials 17 and the plurality of fiber bundles 18 overlap, the formation of the plurality of regions adjacent to each other are such that the positions of the thermally conductive materials 17 and the fiber bundles 18 in the thickness direction of the skin 12 or the skin 13 are alternately switched.

Note that the above-mentioned regions refer to regions where the thermally conductive materials 17 and the plurality of fiber bundles 18 overlap in the thickness direction of the skin 12. Although FIG. 4 shows the plurality of regions adjacent to each other without a gap, the plurality of regions may be adjacent to each other with a gap therebetween depending on the width of each of the plurality of thermally conductive materials 17 and the plurality of fiber bundles 18.

Although FIG. 4 shows a case where the thermally conductive materials 17 are present in four rows in the vertical direction and the fiber bundles 18 are present in four rows in the horizontal direction, and the four thermally conductive materials 17 and the four fiber bundles 18 are interwoven together, the number of thermally conductive materials 17 and fiber bundles 18 is not limited to four each. The number of the thermally conductive materials 17 and the number of the fiber bundles 18 are not limited to the same and may be different.

The plurality of thermally conductive materials 17 and the plurality of fiber bundles 18 are interwoven with each other, that is, formed so as to appear alternately on the front and back surface sides, and thus, as shown in FIG. 4, the upper surface of the thermally conductive layer 16 has a checkered pattern. That is, the thermally conductive materials 17 and the fiber bundles 18 appear alternately on the upper surface or the lower surface.

The plurality of thermally conductive materials 17 and the plurality of fiber bundles 18 are preferably interwoven alternately one by one, but may be interwoven, for example, with two thermally conductive materials 17 as a pair or, for example, with two fiber bundles 18 as a pair.

Even when the thermally conductive material 17 or the fiber bundle 18 is interwoven in a plurality of pieces or in a plurality of rows as a pair, the region where the thermally conductive materials 17 and the fiber bundles 18 formed for each pair overlap is one region. That is, in the regions formed for each pair, the positions of the thermally conductive materials 17 and the fiber bundles 18 in the thickness direction of the skin 12 or the skin 13 in the plurality of regions adjacent to each other should be alternately switched.

The plurality of thermally conductive materials 17 and the plurality of fiber bundles 18 are interwoven with each other, forming a unified thermally conductive layer 16 without separating from each other.

Although FIG. 4 shows an example in which the plurality of thermally conductive materials 17 and the plurality of fiber bundles 18 are orthogonal to each other, the plurality of thermally conductive materials 17 and the plurality of fiber bundles 18 may not be orthogonal to each other, and for example, the angle formed by the plurality of thermally conductive materials 17 and the plurality of fiber bundles 18 may be greater than 0° and less than 90°.

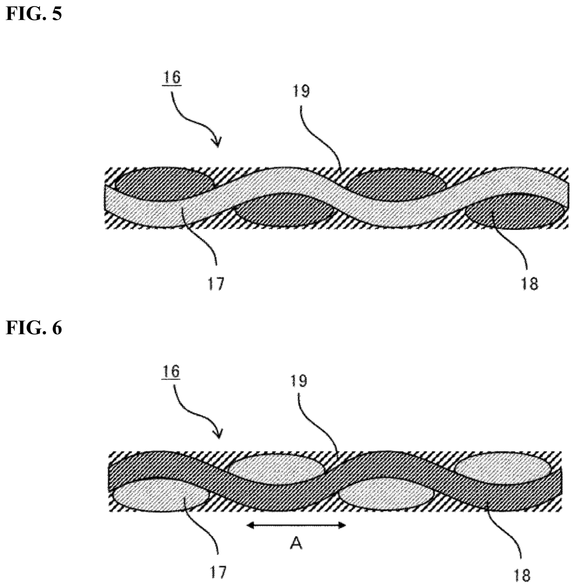

FIG. 5 is a schematic diagram corresponding to a cross section of the thermally conductive layer 16 arrowed at a line C-C' in FIG. 4 according to Embodiment 1.

As shown in FIG. 5, the thermally conductive material 17 alternately passes above and below the plurality of fiber bundles 18. Alternatively, two fiber bundles 18 may be considered as one pair, and the thermally conductive material 17 may alternately pass through the upper and lower sides of each pair.

The thermally conductive material 17 passes through between the plurality of fiber bundles 18. The thermally conductive material 17 is provided in a meandering manner in the thickness direction of the thermally conductive layer 16. That is, the thermally conductive layer 16 has tensile strength and elasticity in the extending direction of the thermally conductive material 17.

The thermally conductive layer 16 has tensile strength and elasticity in the extending direction of the thermally conductive material 17, and thus when a load is applied in the extending direction of the thermally conductive material 17, it is possible to prevent tensile stress from being immediately applied to the thermally conductive material 17 in a non-slackened state.

As shown in FIG. 5, the thermally conductive layer 16 includes gap portions 19 where the thermally conductive materials 17 and the fiber bundles 18 are not present. The gap portion 19 is filled with resin.

The plurality of thermally conductive materials 17 may not be arranged without gaps, and the gap portions 19 may be present between the plurality of thermally conductive materials 17. When the gap portions 19 are present between the plurality of thermally conductive materials 17, the resin filled in the gap portions 19 may appear on the upper surfaces of the thermally conductive layers 16.

When the resin is present in the gap portions 19 between the plurality of thermally conductive materials 17, the upper surface of the thermally conductive layer 16 may not have a complete checkered pattern in which only the thermally conductive materials 17 and the fiber bundles 18 appear as shown in FIG. 4, but may have a check pattern in which the plurality of thermally conductive materials 17 and the plurality of fiber bundles 18 alternately appear and regions filled with the resin are further scattered between the plurality of thermally conductive materials 17 and the plurality of fiber bundles 18.

FIG. 6 is a schematic diagram corresponding to a cross section of the thermally conductive layer 16 arrowed at a line D-D' in FIG. 4 according to Embodiment 1.

As shown in FIG. 6, the fiber bundle 18 alternately passes above and below the plurality of thermally conductive materials 17. Alternatively, two thermally conductive materials 17 may be considered as one pair, and the fiber bundles 18 may alternately pass through the upper and lower sides of each pair.

The fiber bundle 18 passes through between the plurality of thermally conductive materials 17. The fiber bundle 18 is provided in a meandering manner in the thickness direction of the thermally conductive layer 16. That is, the thermally conductive layer 16 has tensile strength and elasticity in the extending direction of the fiber bundle 18.

The thermally conductive layer 16 has tensile strength and elasticity in the extending direction of the fiber bundle 18, and thus, when a load is applied in the extending direction of the fiber bundle 18, it is possible to prevent tensile stress from being immediately applied to the fiber bundle 18 in a non-slackened state.

As shown in FIG. 6, the thermally conductive layer 16 includes the gap portions 19 where the thermally conductive material 17 and the fiber bundle 18 are not present. The gap portions 19 are filled with resin.

The plurality of fiber bundles 18 may not be arranged without gaps, and the gap portions 19 may be present between the plurality of fiber bundles 18. When the gap portions 19 are present between the plurality of fiber bundles 18, the resin filled in the gap portions 19 may appear on the upper surfaces of the thermally conductive layers 16.

When the resin is present in the gap portions 19 between the plurality of the fiber bundles 18, the upper surface of the thermally conductive layer 16 may not have a complete checkered pattern in which only the thermally conductive materials 17 and the fiber bundles 18 appear as shown in FIG. 4, but may have a check pattern in which the plurality of thermally conductive materials 17 and the plurality of fiber bundles 18 alternately appear and regions filled with the resin are further scattered between the plurality of thermally conductive materials 17 and the plurality of fiber bundles 18.

Further, even when the resin is filled in the gap portions 19 of the thermally conductive layers 16 where the thermally conductive materials 17 and the fiber bundles 18 are not present and the resin covers the plurality of thermally conductive materials 17 and the plurality of fiber bundles 18, the checkered pattern or the check pattern shown in FIG. 4 may appear on the surface of the thermally conductive layer 16 if the resin is transparent.

The thermally conductive materials 17 are interwoven with the fiber bundles 18 extending in the direction different from the extending direction of the thermally conductive materials 17, and the fiber bundles 18 enter between the plurality of thermally conductive materials 17. Thus, when a load is applied in the direction different from the extending direction of the thermally conductive materials 17, the fiber bundles 18 can take on the load applied in the direction different from the extending direction of the thermally conductive materials 17.

The fiber bundle 18 receives the load applied in the direction different from the extending direction of the thermally conductive materials 17, and thus it is possible to suppress the breakage of the thermally conductive materials 17 and the resin filled in the gap portions 19.

The extending direction of the fiber bundles 18 are preferably orthogonal to the extending direction of the thermally conductive materials 17. When the extending direction of the fiber bundles 18 is orthogonal to the extending direction of the thermally conductive materials 17, that is, coincides with the short side direction of the thermally conductive materials 17, the load to be applied to the thermally conductive material 17 can be reduced most, and the heat received by the laminated structure 1 can be diffused efficiently.

Here, thermal expansion of the thermally conductive material 17 and the like will be described.

In general, a material has a thermal expansion property that the volume changes with a temperature change, and the rate of thermal expansion varies depending on the type of the material. That is, even if different types of materials are placed in the same volume and at the same temperature, the amount of thermal expansion caused by a change in temperature will vary depending on the type of material.

When members of different materials are in contact with each other, a member having a small amount of thermal expansion may be deformed by the pulling by a member having a large amount of thermal expansion because there is a difference in the amount of thermal expansion caused by a temperature change.

Further, the larger the temperature change, the larger the amount of thermal expansion, and thus the difference in the amount of thermal expansion between members made of different materials in contact with each other is larger. As the difference in the amount of thermal expansion increases, the force with which a member is pulled also increases, and the possibility of deformation increases.

The laminated structure 1 according to the present embodiment can be mounted on an artificial satellite. In a space environment, a temperature change caused by the presence or absence of solar radiation is particularly large, and for example, the temperature may be -200 °C at a low temperature and 100 °C at a high temperature, and a temperature difference of 300 °C may occur. That is, the laminated structure 1 is subjected to a large temperature change during use.

It is desirable to select a material having a high thermal conductivity for the material of the thermally conductive material 17. However, on the other hand, when a material having a high thermal conductivity is selected, the mechanical properties of the thermally conductive material 17 may be insufficient, meaning it may have less strength to withstand a load.

That is, the thermally conductive material 17 is highly likely to be broken when a load is applied thereto. Since the thermally conductive material 17 mainly serves to conduct heat of the laminated structure 1, when the thermally conductive material 17 is broken, the heat conductivity of the laminated structure 1 is reduced.

The difference in thermal expansion occurs if the materials are different, and the difference in thermal expansion between the thermally conductive material 17 and other members is particularly problematic because the breakage of the thermally conductive material 17 mainly contributes to the decrease in the thermal conductivity.

In the present embodiment, the difference in thermal expansion between the thermally conductive material 17 and the heat generating device 2 is particularly large. Therefore, by forming the thermally conductive layer 16 so as to cope with the difference in thermal expansion between the thermally conductive material 17 and the heat generating device 2, the effect of suppressing the breakage of the thermally conductive material 17 can be further enhanced.

The difference in thermal expansion between the thermally conductive material 17 and the heat generating device 2 is largest in the direction A shown in FIG. 1. FIG. 1 shows an example in which the heat generating device 2 is a rectangular parallelepiped, and the direction of the long side of the heat generating device 2 in a plane including the skin 12 is defined as the direction A.

It is desirable that the extending direction of the thermally conductive material 17 is different from the direction A, that is, different from the long side direction of the heat generating device 2.

The extending direction of the thermally conductive material 17 is arranged to be different from the direction A, and thus the length of the thermally conductive material 17 in the direction A is smaller than that in a case where the thermally conductive material 17 is provided such that the extending direction of the thermally conductive material 17 is the same as the direction A. When the length of the thermally conductive material 17 in the direction A is small, the length of the thermally conductive material 17 affected by the pulling in the direction A is also small.

That is, it is possible to further reduce the possibility that the thermally conductive material 17 is broken by the pulling in the direction A.

Further, the extending direction of the thermally conductive material 17 is arranged in a direction different from the direction A, and thus the thermally conductive material 17 itself carries out a role to transport the heat transmitted to the thermally conductive material 17 from the heat generating device 2, that is, the thermally conductive material 17 promotes the diffusion of the heat.

Furthermore, it is more desirable that the thermally conductive material 17 is arranged such that the short side direction of the thermally conductive material 17 is the same as the direction A, that is, the thermally conductive material 17 is arranged such that the extending direction of the thermally conductive material 17 is orthogonal to the direction A.

By arranging the thermally conductive material 17 such that the extending direction of the thermally conductive material 17 is orthogonal to the direction A, the length of the thermally conductive material 17 in the direction A is further reduced, and the possibility of the thermally conductive material 17 being broken can be reduced.

In addition, since the extending direction of the thermally conductive material 17 is arranged to be orthogonal to the direction A, the thermally conductive material 17 itself carries out a role to transport the heat transmitted to the thermally conductive material 17 from the heat generating device 2, that is, the thermally conductive material 17 further promotes the diffusion of the heat.

The tensile strength of the fiber bundle 18 is preferably higher than the tensile strength of the thermally conductive material 17. Using the fiber bundle 18 having a tensile strength higher than that of the thermally conductive material 17 allows the fiber bundle 18 to take on the load. By allowing the fiber bundle 18 to take on the load, it is possible to suppress the breakage of the thermally conductive layer 16. In particular, the thermal conductive material 17 included in the thermally conductive layer 16 can be prevented from being broken.

It is desirable that the fiber bundle 18 is provided such that the extending direction of the fiber bundle 18 is different from the direction orthogonal to the direction A, that is, the short side direction of the heat generating device 2.

By providing the fiber bundle 18 such that the extending direction of the fiber bundle 18 is different from the direction orthogonal to the direction A, the component of the load in the direction A taken on by the fiber bundle 18 is increased as compared with a case where the extending direction of the fiber bundle 18 is arranged in the direction orthogonal to the direction A. The component of the load in the direction A taken on by the fiber bundle 18 increases, and thus the fiber bundle 18 can take on more of the load applied in the direction A.

The fiber bundle 18 is to be able to take on more of the load applied in the direction A, and thus it is possible to further reduce the possibility that the thermally conductive material 17 and the resin filled in the gap portions 19 are to be broken.

Further, it is more desirable that the extending direction of the fiber bundle 18 is the same as the direction A, that is, the same as the long side direction of the heat generating device 2.

By providing the extending direction of the fiber bundle 18 in the same direction as the direction A, the component of the load in the direction A taken on by the fiber bundle 18 is larger, and the fiber bundle 18 can take on the load to be applied in the direction A more.

The fiber bundle 18 is to be able to take on more of the load applied in the direction A, and thus it is possible to further reduce the possibility that the thermally conductive material 17 and the resin filled in the gap portions 19 are broken.

The skin outer layer 14 and the skin outer layer 15 include a fiber reinforced plastic. The skin outer layer 14 and the skin outer layer 15 are formed of the fiber reinforced plastic, and thus the weight can be reduced.

The fiber reinforced plastic used for the skin outer layer 14 and the skin outer layer 15 may be a laminated material of continuous fibers or may be a material using discontinuous fibers such as short fibers or long fibers.

The skin outer layer 14 and the skin outer layer 15 may be made of the same material or different materials.

The skin outer layer 14 and the skin outer layer 15 may also be deformed or broken due to a difference in thermal expansion between the heat generating device 2 and them.

When the continuous fibers of carbon fibers are used for the skin outer layer 14 and the skin outer layer 15, it is desirable to control the fiber orientation and the fiber content so that the difference in thermal expansion between the heat generating device 2 and the skin outer layer 14 as well as between the heat generating device 2 and the skin outer layer 15 is reduced.

The fiber orientation can be controlled and the fibers are laminated so that the difference in thermal expansion as the physical property between the heat generating device 2 and the skin outer layer 14 as well as between the heat generating device 2 and the skin outer layer 15 is to be desirable, and the ratio of the resin and the fibers can be controlled in an impregnation step.

The fiber bundle 18 preferably contains carbon fibers. For example, it is desirable to use Polyacrylonitrile (PAN) based carbon fibers for the fiber bundle 18. Since the PAN based carbon fibers have higher strength than other fibers, the fiber bundle 18 can withstand a large load.

When a temperature change occurring in a use environment is large or when deformation due to a difference in thermal expansion is considered to be large, it is desirable to use a fiber having higher strength among the PAN based carbon fibers.

When it is considered that the load applied to the fiber bundle 18 is not large, it is desirable to use a pitch-based carbon fiber.

By using the pitch-based carbon fibers having high thermal conductivity, the thermal conductivity of the fiber bundle 18 is improved, and the ability of the thermally conductive layer 16 to transport heat can be improved.

Further, when it is considered that the load applied to the fiber bundle 18 is not large, inorganic fibers such as glass fibers or ceramic fibers may be used for the fiber bundle 18.

It is desirable to use a material having a thermal conductivity of 300 W/mK or more for the thermally conductive material 17. By using a material having the thermal conductivity of 300 W/mK or more, a high heat dissipation capability can be obtained compared to the case of using aluminum or the like.

For example, it is desirable to use highly thermally conductive graphite as a material of the thermally conductive material 17. Note that a composite material using the pitch-based carbon fibers, carbon nanotubes, or the like may be used.

When the skin 12 or the skin 13 includes the thermally conductive layer 16, the thicknesses of the skin outer layer 14 or the skin outer layer 15 in the lamination direction is, for example, about 0.1 mm to 2 mm. The thermally conductive layer 16 is, for example, about 0.01 mm to 1 mm thick in the lamination direction. When the skin 12 or the skin 13 does not include the thermally conductive layer 16, the skin outer layer 15 is, for example, about 0.5 mm to 5 mm thick in the lamination direction. The core 11 is, for example, about 10 mm to 200 mm thick in the lamination direction.

In the present embodiment, the case where the thermally conductive material 17 is rectangular is used as an example, but the plurality of thermally conductive materials 17 may be partially connected.

The widths of the plurality of thermally conductive materials 17, that is, the dimensions in the short side direction may be the same or different. The thickness of the plurality of thermally conductive materials 17, that is, the dimension in the lamination direction of the core 11, the skin 12, the skin 13, and the like of the laminated structure 1 may be the same or different.

Further, the plurality of fiber bundles 18 may be partially connected to each other.

The widths of the plurality of fiber bundles 18, that is, the dimensions in the direction perpendicular to the extending direction may be the same or different. The thickness of the plurality of fiber bundles 18, that is, the dimension in the lamination direction of the core 11, the skin 12, the skin 13, and the like of the laminated structure 1 may be the same or different.

The resin filled in the gap portions 19 is preferably the same resin as the resin used for the skin outer layer 14 or the skin outer layer 15. The resin may be formed through resin entering into the gap portions 19 when the skin outer layer 14 or the skin outer layer 15 is formed.

The same resin as the resin used for the skin outer layer 14 or the skin outer layer 15 is used for the gap portions 19, and thus the gap portions 19 are integrally molded simultaneously with the skin outer layer 14 or the skin outer layer 15, whereby the strength of the gap portions 19 can be increased.

In addition, an adhesive used when the skin outer layer 14 or the skin outer layer 15 is bonded to the thermally conductive materials 17 or the fiber bundles 18 may be used in the gap portions 19.

The skin 13 may be formed in the same manner as the skin 12. Further, the skin 13 may not include the thermally conductive layer 16, unlike the skin 12. Furthermore, the skin 13 may be formed of a material different from that of the skin 12, and may be formed of, for example, an aluminum alloy.

The skin may be provided on at least one surface of the core 11. That is, both the skin 12 and the skin 13 are not necessarily provided, and only one of them may be provided.

### Embodiment 2

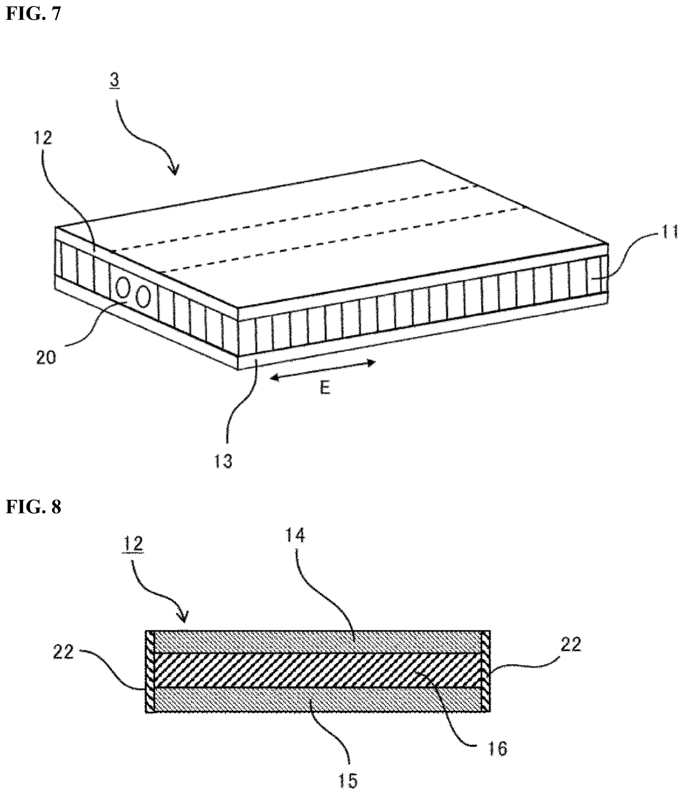

A laminated structure 3 according to Embodiment 2 will be described with reference to FIG. 7. The description of the same configuration as that of Embodiment 1 will be omitted. In FIG. 7, the same reference numerals as those in FIG. 1 to FIG. 6 denote the same or corresponding components.

FIG. 7 is a perspective view of the laminated structure 3 according to Embodiment 2. As shown in FIG. 7, the laminated structure 3 according to the present embodiment is different from the laminated structure 3 of Embodiment 1 in that the laminated structure 3 includes a heat pipe 20 inside the core 11. The following description will be focused on the differences from the laminated structure 3 of Embodiment 1.

As shown in FIG. 7, the heat pipe 20 is provided inside the core 11. The broken lines in FIG. 7 indicate that the heat pipe 20 is provided at a position between the broken lines.

The heat pipe 20 penetrates the laminated structure 3 according to Embodiment 2 and extends in the left and right direction of the paper of FIG. 7. The heat pipe 20 extending from the laminated structure 3 is connected to a device such as a radiator (not shown) in a region (not shown). The laminated structure 3 receives heat from sunlight or the like. The heat received by the laminated structure 3 is transmitted to the heat pipe 20, and the heat pipe 20 transports the heat. The heat received by the heat pipe 20 is received by the radiator, and the heat transmitted to the radiator is dissipated from the radiator by radiation.

A direction E shown in FIG. 7 is an extending direction of the heat pipe 20. When the heat pipe 20 has, for example, a cylindrical shape, the extending direction of the heat pipe 20 is the height direction of the cylinder. Further, the cross-sectional direction of the heat pipe 20 is a direction of a circular face corresponding to a bottom of the heat pipe 20 when the heat pipe 20 is a bottomed cylinder.

The heat pipe 20 is not limited to a cylindrical shape.

In the present embodiment, the difference in the thermal expansion between the thermally conductive material 17 and the heat pipe 20 is particularly large. Therefore, by forming the thermally conductive layer 16 so as to cope with the difference in the thermal expansion between the thermally conductive material 17 and the heat pipe 20, the effect of suppressing the breakage of the thermally conductive material 17 can be further increased.

The difference in the amount of the thermal expansion between the thermally conductive material 17 and the heat pipe 20 is largest in the direction E shown in FIG. 7. FIG. 7 shows an example in which the heat pipe 20 is cylindrical, and the height direction of the cylinder, that is, the extending direction is the direction E.

It is desirable that the extending direction of the thermally conductive materials 17 is different from the direction E, that is, different from the extending direction of the heat pipe 20.

Since the extending direction of the thermally conductive material 17 is different from the direction E, the component of the load in the direction E taken on by the thermally conductive material 17 is smaller than that in the case where the thermally conductive material 17 is provided such that the extending direction of the thermally conductive material 17 is the same as the direction E. When the component of the load in the direction E taken on by the thermally conductive material 17 is small, the length of the thermally conductive material 17 affected by the pulling in the direction E is also small.

That is, it is possible to further reduce the possibility of the breakage of the thermally conductive material 17 with the thermally conductive material 17 pulled in the direction E.

Further, the extending direction of the thermally conductive material 17 is provided in a direction different from the direction E, and thus the thermally conductive material 17 itself carries out a role to transport the heat transmitted to the thermally conductive material 17 from the heat pipe 20, that is, the thermally conductive material 17 promotes the diffusion of the heat.

Furthermore, it is more desirable that the thermally conductive material 17 is provided such that the short side direction of the thermally conductive material 17 is the same direction as the direction E, that is, the thermally conductive material 17 is arranged such that the extending direction of the thermally conductive material 17 is orthogonal to the direction E.

By arranging the thermally conductive material 17 such that the extending direction of the thermally conductive material 17 is orthogonal to the direction E, the component of the load in the direction E taken on by the thermally conductive material 17 is further reduced, and the possibility of the breakage of the thermally conductive material 17 can be reduced.

Further, the extending direction of the thermally conductive material 17 is arranged to a direction orthogonal to the direction E, and thus the thermally conductive material 17 itself carries out a role to transport the heat transmitted to the thermally conductive material 17 from the heat pipe 20, that is, the thermally conductive material 17 promotes more the diffusion of the heat.

The tensile strength of the fiber bundle 18 is preferably higher than the tensile strength of the thermally conductive material 17. By using the fiber bundle 18 having a higher tensile strength than the thermally conductive material 17 and allowing the fiber bundle 18 to take on the load, it is possible to suppress the breakage of the thermally conductive layer 16.

It is desirable that the fiber bundle 18 is provided such that the extending direction of the fiber bundle 18 is different from the direction orthogonal to the direction E, that is, the cross-sectional direction of the heat pipe 20.

By providing the fiber bundle 18 such that the extending direction of the fiber bundle 18 is different from the direction orthogonal to the direction E, the component of the load in the direction E taken on by the fiber bundle 18 is increased as compared with the case where the extending direction of the fiber bundle 18 is provided in the direction orthogonal to the direction E. The component of the load in the direction E taken on by the fiber bundle 18 increases, and thus the fiber bundle 18 can take on more of the load applied in the direction E.

Since the fiber bundle 18 can take on more of the load applied in the direction E, the possibility that the thermally conductive material 17 and the resin filled in the gap portion 19 are broken can be further reduced.

Further, it is more desirable that the extending direction of the fiber bundle 18 is the same as the direction E, that is, the extending direction of the heat pipe 20.

When the extending direction of the fiber bundle 18 provided is the same as the direction E, the component of the load in the direction E taken on by the fiber bundle 18 is increased, and the fiber bundle 18 can take on more of the load applied in the direction E.

Since the fiber bundle 18 can take on more of the load applied in the direction E, the possibility that the thermally conductive material 17 and the resin filled in the gap portion 19 are broken can be further reduced.

Although the heat generating device 2 is not shown in FIG. 7, the laminated structure 3 according to the present embodiment may be provided adjacent to the heat generating device 2, as in the case of the laminated structure shown in FIG. 2 in Embodiment 1.

The laminated structure 3 receives heat from the heat generating device 2. The heat generated by the heat generating device 2 is transmitted to the skin 12 adjacent to the heat generating device 2. The heat transferred to the skin 12 is transferred to the skin 13 which is not adjacent to the heat generating device 2 through the core 11 and is dissipated by radiation.

The heat transferred to the skin 12 or the skin 13 is transferred to a device such as a radiator (not shown) connected to the heat pipe 20 via the heat pipe 20 included in the core 11.

Further, the extending direction of the thermally conductive material 17 is arranged to the direction different from the direction E, and thus the thermally conductive material 17 itself carries out a role to transport the heat transmitted to the thermally conductive material 17 from the heat generating device 2, that is, the thermally conductive material 17 promotes the transmission of the heat to the heat pipe 20.

Furthermore, the extending direction of the thermally conductive material 17 is arranged to the direction orthogonal to the direction E, and thus the thermally conductive material 17 itself carries out a role to transport the heat transmitted to the thermally conductive material 17 from the heat generating device 2, that is, the thermally conductive material 17 further promotes the transmission of the heat to the heat pipe 20.

### Embodiment 3

A skin 12 according to Embodiment 3 will be described with reference to FIG. 8. The description of the same configuration as that of Embodiment 1 will be omitted. In FIG. 8, the same reference numerals as those in FIG. 1 to FIG. 7 denote the same or corresponding components.

FIG. 8 is a schematic view corresponding to a cross section of the skin 12 arrowed at the line B-B' in FIG. 1 according to Embodiment 3. The skin 12 according to the present embodiment is different from the skin 12 of Embodiment 1 in that an insulating portion 22 is provided as shown in FIG. 8. The following description will be focused on the differences from the skin 12 of Embodiment 1.

As shown in FIG. 8, the insulating portion 22 is provided at edges of the skin 12.

For example, an epoxy resin, a fluororesin, or the like may be used for the insulating portion 22.

When a carbon-based material is used for the thermally conductive layer 16 and an aluminum alloy or the like is used for the core 11 or the heat pipe 20, galvanic corrosion may occur due to a potential difference between carbon and aluminum.

By providing the insulating portion 22 at the edges of the skin 12, galvanic corrosion of the laminated structure 1 and the laminated structure 3 can be suppressed. Since galvanic corrosion can be suppressed, formation of corrosion products on the core 11 and the heat pipe 20 can be suppressed, and a decrease in the heat transport capability of the laminated structure 1 and the laminated structure 3 can be suppressed.

The insulating portion 22 is preferably provided in the entire edges of the skin 12, but may be provided in a part of the edges.

The insulating portion 22 may be provided at edges of the core 11. The insulating portion 22 may be provided on at least one of the skin 12 and the core 11.

When the insulating portion 22 is provided on the skin 12, the processing is easier than when the insulating portion 22 is provided on the edges of the core 11.

The skin provided on the surface of the core 11 opposite to the skin 12 may be the same as or different from the skin 12, and may be the same as or different from the skin 13.

The method for manufacturing the thermally conductive layer 16 according to Embodiment 1 to Embodiment 3 includes a step of weaving the plurality of thermally conductive materials 17 and the plurality of fiber bundles 18. The plurality of thermally conductive materials 17 and the plurality of fiber bundles 18 are to be interwoven as warp and weft, respectively.

The method for manufacturing the thermally conductive layer 16 according to Embodiment 1 to Embodiment 3 includes a step of impregnating the interwoven material of the plurality of thermally conductive materials 17 and the plurality of fiber bundles 18 with a resin to fill the gap portions 19 with the resin.

In each of the embodiments described in the present specification, the material, size, shape, relative arrangement relationship, implementation conditions, and the like of each component may have been described. However, these are examples in all aspects, and the embodiments are not limited to those described. Therefore, innumerable modifications not illustrated are assumed within the scope of each embodiment. For example, a case where an arbitrary component is modified, added, or omitted, and a case where at least one component in at least one embodiment is extracted and combined with a component in another embodiment may be included.

It is needless to say that various design changes can be made within the scope of the present invention.

### Description of Symbols

- 1, 3:: laminated structure
- 2:: heat generating device
- 11:: core
- 12:: skin
- 13:: skin
- 14:: skin outer layer
- 15:: skin outer layer
- 17:: thermally conductive material
- 18:: fiber bundle
- 20:: heat pipe
- 22:: insulating portion

## Claims

1. A laminated structure comprising:
a core; and
a skin provided on at least one surface of the core, wherein
the skin includes a plurality of thermally conductive materials extending in a plane including the skin, and a plurality of fiber bundles extending in a direction different from the extending direction of the thermally conductive materials in the plane including the skin, and
in a plurality of regions where the plurality of thermally conductive materials and the plurality of fiber bundles overlap, formation of the plurality of regions adjacent to each other are such that positions of the thermally conductive materials and the fiber bundles in the thickness direction of the skin are alternately switched.

2. The laminated structure according to claim 1,
wherein the skin is provided adjacent to a heat generating device.

3. The laminated structure according to claim 2,
wherein an extending direction of the fiber bundles is different from a short side direction of the heat generating device.

4. The laminated structure according to claim 1 or 2,
wherein a heat pipe is provided inside the core.

5. The laminated structure according to claim 4,
wherein an extending direction of the fiber bundles is different from a cross-sectional direction of the heat pipe.

6. The laminated structure according to claim 3 or 5,
wherein tensile strength of the fiber bundles is higher than tensile strength of the thermally conductive materials.

7. The laminated structure according to any one of claims 1 to 6,
wherein the thermally conductive materials have a thermal conductivity of 300 W/mK or more.

8. The laminated structure according to any one of claims 1 to 7,
wherein the fiber bundles include carbon fibers.

9. The laminated structure according to any one of claims 1 to 8,
wherein the skin comprises a skin outer layer on a core-side surface and on a surface opposite to the core-side surface, and the skin outer layer includes fiber reinforced plastic.

10. The laminated structure according to any one of claims 1 to 9,
wherein an insulating portion is provided at an edge of the skin or the core.
